# EUROPEAN PATENT APPLICATION

(11) **EP 2 346 069 A1**
(43) Date of publication of application: **20.07.2011**
(21) Application number: 09824690.3
(22) Date of filing: 07.10.2009
(51) Int. Cl.: H01L 21/304, B24B 37/00, C09K 3/14

(54) **ABRASIVE, POLISHING METHOD, METHOD FOR MANUFACTURING SEMICONDUCTOR INTEGRATED CIRCUIT DEVICE**

(30) Priority: 07.11.2008 JP 2008286366
(71) Applicant: Asahi Glass Company Limited, Chiyoda-ku Tokyo 100-8405 (JP)
(72) Inventor: SUZUKI Masaru, Tokyo 100-8405 (JP); NAKAZAWA Norihito, Tokyo 100-8405 (JP)
(74) Representative: Hock, Joachim
(86) International application number: PCT/JP2009/067519
(87) International publication number: WO 2010/052990

(57) **Abstract**

The present invention relates to a polishing method for polishing a to-be-polished surface including a polysilicon film having a silicon dioxide film directly thereunder, in manufacturing a semiconductor integrated circuit device, the method including: a first polishing step of polishing and planarizing the polysilicon film with a first abrasive containing a cerium oxide particle, water and an acid; and a second polishing step of polishing the polysilicon film planarized in the first polishing step with a second abrasive containing at least a cerium oxide particle, water, an acid and a water-soluble polyamine or a salt thereof and stopping polishing by exposure of the silicon dioxide film.

## Description

### TECHNICAL FIELD

The present invention relates to an abrasive for chemical mechanical polishing in the manufacture of a semiconductor integrated circuit device, a polishing method and a method for manufacturing a semiconductor integrated circuit device. In more detail, the invention relates to an abrasive and a polishing method suitable for planarizing a to-be-polished surface including a polycrystalline silicon (hereinafter referred to as a "polysilicon") film which is used for capacitors, gate electrodes and the like in a step of forming a multilayered wiring of a semiconductor integrated circuit device, and a method for manufacturing a semiconductor integrated circuit device using the polishing method.

### BACKGROUND ART

In recent years, following upon high integration and high functionalization of semiconductor integrated circuit devices, the development of a micromachining technology for microfabrication and high densification of elements has been demanded. In particular, importance of a planarization technology by chemical mechanical polishing (hereinafter referred to as "CMP") is increasing.

For example, with progress of miniaturization of semiconductor integrated circuit devices and multilayering of wirings, the surface irregularity (difference in level) in each layer in the manufacturing process tends to increase. In order to prevent such a problem that this difference in level exceeds the depth of focus in photolithography so that sufficient resolution is not obtained, CMP has become an indispensable technology. Specifically, CMP is adopted for planarization of inter-level dielectrics (ILD film), shallow trench isolation (STI), tungsten plug formation, a forming step of a multilayered wiring composed of copper and a low-dielectric film, and the like. In such cases, a polysilicon film is frequently used for capacitors, gate electrodes and the like, and CMP is also adopted for planarization of a to-be-polished surface including a polysilicon film.

In a manufacturing process of a semiconductor integrated circuit device, in performing the planarization of a to-be-polished surface including a polysilicon film, by film-forming a silicon dioxide film as a stopper layer in a lower layer of the polysilicon that is subjective to polishing and making a ratio of a polishing rate of the polysilicon film and a polishing rate of the silicon dioxide film (the terms "(polishing rate of A)/(polishing rate of B)" will be hereinafter referred to as a "polishing rate ratio of A and B") large, when the stopper layer is exposed, the planarization of the to-be-polished surface has been able to be realized.

As an abrasive for the planarization of the to-be-polished surface including this polysilicon film, there has been proposed a composition composed of an abrasive grain of at least one of fused silica and colloidal silica and an amine that is a basic compound (see, for example, Patent Document 1). However, in the case of using this polishing composition, there was involved such a problem that not only a portion which is desired to be polished but also a portion which is desired to be left are removed by chemical etching, whereby a hollow which is called dishing is easily formed.

Also, as a polishing method of the to-be-polished surface including a polysilicon film, there has been proposed a technology in which after planarization with a polishing composition containing a cerium oxide particle, the resulting to-be-polished surface is further polished with an abrasive containing a silicon dioxide (silica) abrasive grain (see, for example, Non-Patent Document 1). According to this Non-Patent Document 1, it is mentioned that polishing with the polishing composition containing a cerium oxide particle has nonlinearity against the pressure, and only a portion where a high pressure is applied can be polished, and therefore, planarization can be performed while suppressing dishing. Then, it is mentioned that by subsequently polishing and removing the remaining polysilicon film with the silicon dioxide abrasive grain, a highly planarized to-be-polished surface can be obtained.

However, in the polishing method presented in Non-Patent Document 1, since polishing is carried out by combining compositions for polishing (abrasives) containing abrasive grains of a different kind from each other (a cerium oxide particle and a silicon dioxide particle), respectively, the whole of the supply mechanism of the abrasives becomes complicated, leading to an increase of costs or installation space of equipment. Also, there was involved such a problem that in view of mixing two kinds of abrasive grains, aggregation of the abrasive grains is generated, whereby the generation of polishing flaws or deterioration of the planarity is easily caused.

### BACKGROUND ART DOCUMENT

### Patent Documents

Patent Document 1: Japanese Patent No. 3457144 (working examples)

### Non-Patent Documents

Non-Patent Document 1: "Planarization of the Poly-Si gate for Non Volatile Memories", L. Baud, L. Canavari, C. Romanelli, G. Spinolo, M. Rivoire, International Conference of Planarization/CMP Technology proceedings October, 2007P87-91

### SUMMARY OF THE INVENTION

### PROBLEMS THAT THE INVENTION IS TO SOLVE

In order to solve these problems, the invention has been made, and an object thereof is to provide an abrasive and a polishing method which are suitable for chemically mechanically polishing a to-be-polished surface including a polysilicon film and capable of performing high planarization without generating dishing or polishing flaws in manufacturing a semiconductor integrated circuit device. Still other objects and advantages of the invention will be clarified from the following description.

### MEANS FOR SOLVING THE PROBLEMS

A first embodiment of the invention is concerned with a polishing method for polishing a to-be-polished surface including a polysilicon film having a silicon dioxide film directly thereunder, in manufacturing a semiconductor integrated circuit device, the method comprising: a first polishing step of polishing and planarizing the polysilicon film with a first abrasive containing a cerium oxide particle, water and an acid; and a second polishing step of polishing the polysilicon film planarized in the first polishing step with a second abrasive containing at least a cerium oxide particle, water, an acid and a water-soluble polyamine or a salt thereof and stopping polishing by exposure of the silicon dioxide film.

A second embodiment of the invention is concerned with a polishing method for polishing a to-be-polished surface including a polysilicon film having a silicon dioxide film directly thereunder, in manufacturing a semiconductor integrated circuit device, the method comprising: a first polishing step of polishing and planarizing the polysilicon film with a first abrasive containing a cerium oxide particle, water and an acid; and a second polishing step of polishing the polysilicon film planarized in the first polishing step with a second abrasive prepared by adding a water-soluble polyamine and water to the first abrasive and stopping polishing by exposure of the silicon dioxide film.

A third embodiment of the invention is concerned with an abrasive for polishing a to-be-polished surface including a polysilicon film having a silicon dioxide film directly thereunder, in manufacturing a semiconductor integrated circuit device, the abrasive containing a cerium oxide particle, water, an acid and a water-soluble polyamine or a salt thereof; and having a pH of from 7 to 13. Additionally, a fourth embodiment of the invention is concerned with a method for manufacturing a semiconductor integrated circuit device, the method including a step of polishing a to-be-polished surface by the polishing method according to the first and second embodiments.

### ADVANTAGE OF THE INVENTION

According to the polishing method of the invention, in manufacturing a semiconductor integrated circuit device, in a first polishing step of polishing a to-be-polished surface including a polysilicon film, a difference in level between a recess and a projection of the polysilicon film can be planarized while suppressing dishing; and furthermore, in a second polishing step, an appropriate polishing rate ratio can be obtained between the polysilicon film and a silicon dioxide film directly thereunder. Accordingly, the to-be-polished surface including a polysilicon film can be highly planarized with efficiency.

Also, according to the abrasive of the invention, in manufacturing a semiconductor integrated circuit device, in the case of polishing a to-be-polished surface including a polysilicon film, since an appropriate polishing rate ratio can be obtained between the polysilicon film and the silicon dioxide film directly thereunder, it is possible to realize high planarization of the to-be-polished surface.

### BRIEF DESCRIPTION OF THE DRAWINGS

Figs. 1(a) to 1(c) are each a sectional view showing a state of polishing of a to-be-polished surface including a polysilicon film in an embodiment of the invention.
Fig. 2 is a view showing an example of a polishing machine which can be used for a polishing method of the invention.

### MODE FOR CARRYING OUT THE INVENTION

Embodiments of the invention are described using drawings, tables, formulae, working examples and the like. Incidentally, these drawing, tables, formulae, working examples and descriptions exemplify the invention but do not restrict the scope of the invention. Other embodiments can fall within the scope of the invention so far as they are in agreement with the gist of the invention. Also, in the drawings, the same symbol represents the same element.

The polishing method of an embodiment of the invention is concerned with a polishing method for chemically mechanically polishing a to-be-polished surface including a polysilicon film having a silicon dioxide film directly thereunder, in manufacturing a semiconductor integrated circuit device (hereinafter also referred to as a "semiconductor device"), which includes a first polishing step of polishing and planarizing a polysilicon film with a first abrasive containing a cerium oxide particle, water and an acid; and a second polishing step of polishing the polysilicon film planarized in the first polishing step with a second abrasive containing a cerium oxide particle, water, an acid and a water-soluble polyamine or a salt thereof and stopping polishing at a point of time when the silicon dioxide film directly provided thereunder is exposed.

Incidentally, in the invention, the polysilicon film may be included in two or more places of one semiconductor device. Also, the "to-be-polished surface" means a surface at the middle stage appearing in a process of manufacturing a semiconductor device.

In the embodiment of the invention, the first abrasive which is used in the first polishing step is an abrasive for chemically mechanically polishing the to-be-polished surface including a polysilicon film and contains a cerium oxide particle, water and an acid, respectively. A dispersant may also be made coexistent.

In the first polishing step using the first abrasive containing a cerium oxide particle, a polishing rate of the to-be-polished surface relative to the polysilicon film has nonlinearity against the pressure, and a projection to which a higher pressure is applied can be selectively polished at a high speed. Accordingly, a difference in level between a recess and a projection of the polysilicon film can be dissolved, and the to-be-polished surface can be planarized. Also, since the first abrasive is free from aggregation of the cerium oxide particle that is an abrasive grain, it is also excellent in dispersion stability and does not generate polishing defectives.

The second abrasive which is used in the second polishing step is an abrasive for chemically mechanically polishing the to-be-polished surface including a polysilicon film having a silicon dioxide film directly thereunder and contains a cerium oxide particle, water, an acid and a water-soluble polyamine, respectively. A dispersant may also be made coexistent. For the purpose of simplifying the supply mechanism of the abrasives to reduce costs or installation space of equipment, the second abrasive can be a liquid (slurry) obtained by further adding a water-soluble polyamine and water to the first abrasive. When the second abrasive is prepared in such a way, the second abrasive becomes a composition containing a cerium oxide particle, water, an acid and a water-soluble polyamine.

In the polishing of the polysilicon film with the second abrasive, since a negatively charged silanol group is formed on the surface of the polysilicon film due to the presence of the amine substance (water-soluble polyamine) contained in this abrasive, by using the cerium oxide particle in place of the conventionally used silica particle as a polishing abrasive grain, a polishing action by the chemical reaction is enhanced. Accordingly, the second abrasive exhibits a high polishing rate relative to the polysilicon film. Also, since this second abrasive is free from the aggregation of a cerium oxide particle that is an abrasive grain, the second abrasive has such advantages that the dispersion stability is excellent and that a polishing defect is not produced.

In the polishing of the polysilicon film having a silicon dioxide film directly thereunder, when the second abrasive containing a cerium oxide particle, water and a water-soluble polyamine is used, it is possible to make a ratio of a polishing rate (Vps) of the polysilicon film and a polishing rate (Vso) of the silicon dioxide film (namely, a polishing rate ratio Vps/Vso) large. Accordingly, polishing can be easily stopped at a point of time when the silicon dioxide film is exposed, and the irregularity of the polysilicon film that is a to-be-polished surface can be highly planarized. The polishing rate ratio Vps/Vso is preferably 10 or more, and more preferably 20 or more.

Though this second abrasive is an abrasive which is used in the second polishing step of polishing the polysilicon film having been planarized in the foregoing first polishing step while using the silicon dioxide film as a stopper film, its use is not limited to the use for polishing of the polysilicon film after the first polishing step. In the manufacture of a semiconductor integrated circuit device, this second abrasive can be widely used for applications of polishing a to-be-polished surface including a polysilicon film having a silicon oxide film directly thereunder.

As the cerium oxide particle that is an abrasive grain to be blended in the first abrasive and the second abrasive, for example, a cerium oxide particle disclosed in JP-A-11-12561 or JP-A-2001-35818 can be used. That is, a cerium oxide powder obtained by adding an alkali to an ammonium aqueous solution of cerium (IV) nitrate to prepare a cerium hydroxide gel, followed by filtration, washing and firing can be preferably used. Also, a cerium oxide particle obtained by pulverizing and firing cerium carbonate with high purity, followed by further pulverization and classification can be preferably used. However, the cerium oxide particle is not particularly limited thereto. Incidentally, the abrasive grain is preferably composed of only cerium oxide which does not contain silicon dioxide and the like.

From the viewpoints of polishing characteristics and dispersion stability, an average particle size (diameter) of the cerium oxide particle is preferably in the range of from 0.01 to 0.5 µm, more preferably in the range of from 0.02 to 0.3 µm, and still more preferably in the range of from 0.05 to 0.2 µm. When the average particle size is too large, polishing flaws such as scratches and the like are easily produced on the surface of a semiconductor substrate or the like. When the average particle size thereof is too small, there is a concern that the polishing rate becomes too low. Also, since the surface area per unit volume is large, the surface state is easy to give influences. For that reason, there may be the case where the cerium oxide particle is easily aggregated depending upon a condition such as a pH, an additive concentration and the like. When the aggregation occurs, polishing flaws such as scratches and the like are easily produced on the substrate surface.

As the acid which is blended in the first abrasive, there can be exemplified inorganic acids such as nitric acid, sulfuric acid, hydrochloric acid, phosphoric acid, boric acid, carbonic acid and the like; and organic acids such as oxalic acid, citric acid, formic acid, acetic acid, benzenesulfonic acid and the like. A valence of such an acid is preferably not more than 10. Acids having a valence of not more than 8 are more preferable, and acids having a valence of not more than 5 are still more desirable. When an acid falling within this range is used, the dissociation properties are good, and the addition amount of the acid can be suppressed. When an acid having a valence more than the foregoing range is used, the dissociation properties become worse, and the addition amount of the acid becomes large. Incidentally, when an acid of one molecule is one which releases hydrogen ions in a number of n, the acid is called an n-valent acid.

In the first abrasive, by blending such an acid, the abrasive is adjusted at a pH preferably ranging from 3.5 to 6, and more preferably ranging from 4 to 5.5. Since a positive potential of the surface of the cerium oxide particle is raised within this pH range, a dispersant as described later is easy to adsorb onto the surface of the cerium oxide particle. For that reason, even when the concentration of the dispersant is low, the planarization characteristics in polishing of the polysilicon film can be thoroughly revealed.

Though water which is blended in the first abrasive and the second abrasive is not particularly limited, from the viewpoint of minimizing the influences against other components, the incorporation of impurities and the influences against the pH or the like, pure water, ultrapure water, ion-exchanged water (deionized water) and the like can be preferably used. A content of water is preferably from 95.0 to 99.99 % by mass, and especially preferably from 98.0 to 99.5 % by mass.

As the water-soluble polyamine which is blended in the second abrasive, any compound can be used so far as it is a water-soluble compound having two or more amino groups in one molecule thereof. Incidentally, the solubility in water means a state in which the compound is completely dissolved in a liquid of the abrasive in a concentration to be used as an abrasive, and in general, a compound which is soluble in an amount of 1 % by mass or more, and preferably 5 % by mass or more in pure water is referred to herein. Specifically, the water-soluble polyamine is preferably at least one compound selected from the group consisting of a water-soluble polyether polyamine, a water-soluble polyalkylene polyamine, a polyethyleneimine, a water-soluble polyvinylamine, a water-soluble polyallylamine, a water-soluble polylysine and a water-soluble chitosan. In particular, the water-soluble polyamine is preferably a water-soluble polyether polyamine or a water-soluble polyalkylene polyamine. Also, a salt of such a water-soluble polyamine may be blended. As an acid which forms a salt, there can be exemplified inorganic acids such as nitric acid, sulfuric acid, hydrochloric acid, phosphoric acid, boric acid, carbonic acid and the like; and organic acids such as oxalic acid, citric acid, formic acid, acetic acid, benzenesulfonic acid and the like. Furthermore, the salt (neutralized material) formed by the addition of the foregoing water-soluble polyamine to the first abrasive may be blended in the second abrasive.

Though a molecular weight of the water-soluble polyamine is not particularly limited so far as it is a molecular weight falling within the range where the solubility in water is revealed, it is preferably in the range of from 100 to 100,000, and more preferably in the range of from 100 to 2,000 in terms of a weight average molecular weight (Mw). When the weight average molecular weight (Mw) is less than 100, the effects to be brought by blending are small. When the weight average molecular weight (Mw) exceeds 100,000, there is a concern that even a water-soluble compound adversely affects physical properties of the abrasive, such as flowability and the like. When the weight average molecular weight (Mw) exceeds 2,000, the solubility in pure water is often lowered. In particular, the water-soluble polyamine is preferably a water-soluble polyether polyamine or a water-soluble polyalkylene polyamine each having a weight average molecular weight of from 100 to 2,000. From the viewpoint of a high dispersion stabilizing effect against the cerium oxide particle, the weight average molecular weight (Mw) of the water-soluble polyamine is more preferably from 150 to 800, and the weight average molecular weight (Mw) is still more preferably from 150 to 400.

The polyether polyamine as referred to herein means a compound having two or more amino groups and two or more ethereal oxygen atoms. Though the polyether polyamine may have secondary amino groups (-NH-) or tertiary amine groups, it is more preferable that the polyether polyamine has primary amino groups (-NH₂). That is, the polyether polyamine is preferably a compound which has two or more primary amino groups and which does not substantially have other amino group, and especially preferably a polyether diamine having only two primary amino groups.

Also, as the polyether polyamine, a compound having a structure in which hydrogen atoms of hydroxyl groups of a polyhydric alcohol or a polyether polyol are substituted with an aminoalkyl group is preferable. Here, as the polyhydric alcohol, a dihydric to hexahydric alcohol, in particular, a dihydric alcohol is preferable; and as the polyether polyol, a dihydric to hexahydric polyoxyalkylene polyol, in particular, a polyoxyalkylene diol is preferable, As the aminoalkyl group, an amino alkyl group having from 2 to 6 carbon atoms, such as a 2-aminoethyl group, a 2-aminopropyl group, a 2-amino-1-methylethyl group, a 3-aminopropyl group, a 2-amino-1,1-dimethylethyl group, a 4-aminobutyl group and the like, is preferable.

As the polyhydric alcohol, a dihydric alcohol having from 2 to 8 carbon atoms, such as ethylene glycol, diethylene glycol, propylene glycol, dipropylene glycol and the like, is preferable.
This dihydric alcohol may have an ethereal oxygen atom. As the polyether polyol, those in which a repeating unit thereof is an oxyalkylene group having from 2 to 6 carbon atoms, such as a polyethylene glycol (namely, a polyoxyethylene diol), for example, triethylene glycol and tetraethylene glycol; a polypropylene glycol (namely, a polyoxypropylene diol), for example, tripropylene glycol and tetrapropylene glycol; a polyoxyalkylene diol having two or more kinds of oxyalkylene groups, for example, poly(oxypropylene-oxyethylene) diol are preferable.

The polyalkylene polyamine means a compound in which three or more amino groups are each bound through an alkylene group. It is preferred that the terminal amino group is a primary amino group, and that the intramolecular amino group is a secondary amino group. More preferred is a linear polyalkylene polyamine having primary amino groups on both molecular ends and one or more secondary amino groups in a molecule. There are present three or more binding moieties in a molecule, which are each put between an amino group and another amino group and composed of an alkylene group. These plural binding moieties between amino groups may be the same or different from one another. It is preferred that all are the same or that two binding moieties between amino groups binding to the primary amino groups on both ends are the same and different from the other binding moiety (or moieties) between amino groups. The number of carbon atoms contained in one binding moiety between amino groups is preferably from 2 to 8. In particular, it is preferred that the number of carbon atoms contained in each of two binding moieties between amino groups binding to the primary amino groups on both ends is from 2 to 8 and that the number of carbon atoms contained in each of the other binding moieties between amino groups is from 2 to 6.

The foregoing polyether diamine and polyalkylene polyamine are preferably a compound having a structure represented by the following formula (1).

H₂N-(R-X-)ₖ-R-NH₂ (1)

In the formula, R represents an alkylene group having from 2 to 8 carbon atoms; and X represents an oxygen atom or -NH-.
Also, k represents an integer of 2 or more in the case of a polyether diamine and an integer of 1 or more in the case of a polyalkylene polyamine. The plurality of R's within one molecule may be different from each other.

In particular, the polyether diamine is preferably a compound having a structure represented by the following formula (2), and the polyalkylene polyamine is preferably a compound having a structure represented by the following formula (3).

H₂N-R²-O-(R¹-O-)ₘ-R²-NH₂ (2)

H₂N-R⁴-NH-(R³-NH-)ₙ-R⁴-NH₂ (3)

In these formulae, R¹ represents an ethylene group or a propylene group; R² represents an alkylene group having from 2 to 6 carbon atoms; R³ represents an alkylene group having from 2 to 6 carbon atoms; R⁴ represents an alkylene group having from 2 to 8 carbon atoms; m represents an integer of 1 or more; and n represents an integer of 1 or more. R¹ and R² may be the same as or different from each other; and R³ and R⁴ may be the same as or different from each other.

Examples of the polyether diamine represented by the formula (2) include a polyoxypropylene diamine (a compound wherein each of R¹ and R² is a propylene group, and m is 1 or more), a polyoxyethylene diamine (a compound wherein each of R¹ and R² is an ethylene group, and m is 1 or more), a 4,7,10-trioxa-tridecane-1,13-diamine (a compound wherein R¹ is an ethylene group, R² is a trimethylene group, and m is 2) and the like. Examples of the polyalkylene polyamine represented by the formula (3) include tetraethylenepentamine (a compound wherein each of R³ and R⁴ is an ethylene group, and n is 2), pentaethylenehexamine (a compound wherein each of R³ and R⁴ is an ethylene group, and n is 3), heptaethyleneoctamine (a compound wherein each of R³ and R⁴ is an ethylene group, and n is 5), N,N'-bis(3-aminopropyl)-ethylenediamine (a compound wherein R³ is an ethylene group, R⁴ is a trimethylene group, and n is 1), N,N'-bis(2-aminoethyl)-1,4-butanediamine (a compound wherein R³ is a tetramethylene group, R⁴ is an ethylene group, and n is 1) and the like.

Such a water-soluble serves to accelerate polishing of the polysilicon film with the second abrasive and also to suppress the polishing rate relative to the silicon dioxide film. It may be considered that the reason why the addition of the water-soluble polyamine makes it possible to accelerate polishing of the polysilicon film and also to suppress the polishing rate of the silicon dioxide film resides in the matter that the water-soluble polyamine (for example, polyoxypropylene diamine) adsorbs onto the surface of the cerium oxide particle in the second abrasive and the silicon dioxide film of the to-be-polished surface. By such adsorption of the water-soluble polyamine, the contact between the cerium oxide particle and the silicon dioxide film of the to-be-polished surface is inhibited, whereby the progress of polishing of the silicon dioxide film is suppressed. As for the polysilicon film, it may be considered that a silanol group is formed on the surface upon being taken with a chemical change by the water-soluble polyamine, and the surface is easily ground by a mechanical action of the cerium oxide particle that is an abrasive grain, so that the polishing is accelerated.

Of the foregoing water-soluble polyamines, in particular, the use of pentaethylenehexamine (PEHA) or a polyether diamine (for example, polyoxypropylene diamine) is preferable.
In the abrasive including the above-mentioned compound as a water-soluble polyamine, the polishing rate ratio between the polysilicon film and the silicon dioxide film (Vps/Vso) is raised, and at the time of blending of polyoxyethylene diamine, a polishing rate ratio of 20 or more can be achieved, and at the time of blending of PEHA, a polishing rate ratio of even 100 or more can be achieved.

In order to sufficiently obtain the foregoing effects of polishing acceleration of the polysilicon film and polishing suppression of the silicon dioxide film, it is preferable to properly set up a content of the water-soluble polyamine or its salt in the second abrasive within the range of from 0.01 to 20 % by mass, while taking into consideration the polishing rate, uniformity of the abrasive slurry, the weight average molecular weight (Mw) of the water-soluble polyamine, and the like. The content of the water-soluble polyamine or its salt is more preferably in the range of from 0.01 to 5 % by mass with respect to the whole of the second abrasive.

From the viewpoint of dispersibility, a pH of the second abrasive can be allowed to fall within the range of from 4 to 13. However, since the polishing in the second polishing step is more likely accelerated on the alkaline side, the pH is more preferably from 7 to 13. Still more desirably, the pH is set up to the range of from 8 to 13.

In the first abrasive and the second abrasive, other components may be allowed to coexist. Representative examples thereof include a dispersant and a polysilicon film protective agent. The dispersant is a material to be added for the purpose of stably dispersing the cerium oxide particle in a dispersion medium such as pure water and the like. The polysilicon film protective agent is a material which is adsorbed onto a surface of the polysilicon film to protect the surface, whereby dishing is suppressed. The dispersant and the polysilicon film protecting agent may be jointly used. Also, a compound having both a dispersing action and a polysilicon film protecting action (for example, a water-soluble polymer) may be used.

As the dispersant, an anionic, cationic, nonionic or ampholytic surfactant, or a water-soluble polymer having a surface-active action can be used. Here, the surfactant refers to one having a weight average molecular weight (Mw) of not more than 500. Also, it is defined that a compound having an amino group is not included in the surfactant and the water-soluble polymer having a surface-active action. As the surfactant having a weight average molecular weight (Mw) of not more than 500, there can be exemplified an alkylbenzenesulfonic acid salt, a tetraalkylammonium salt, a polyoxyethylene alkyl ether and the like. As the water-soluble polymer having a surface-active action, there can be exemplified a water-soluble polymer having a carboxylate group, such as a polyacrylic acid salt and the like; and other water-soluble polymer such as polyvinylpyrrolidone and the like. In particular, a water-soluble polymer having an ammonium carboxylate group is preferable. Specific examples thereof include a polymer in which at least a part of carboxylic acid groups of polyacrylic acid is substituted with an ammonium carboxylate group (hereinafter referred to as "ammonium polyacrylate") and the like. A weight average molecular weight (Mw) of the water-soluble polymer having a surface-active action is preferably more than 500, and especially preferably in the range of from 800 to 100,000. Examples of the polysilicon film protective agent include a water-soluble polymer such as polyvinylpyrrolidone, polyethylene glycol, polyvinyl alcohol, a polysaccharide and the like. Examples of the polysaccharide include pullulan, cellulose, dextrin, hydroxyethyl cellulose, hydroxypropyl cellulose and the like. In particular, a polysaccharide having a weight average molecular weight (Mw) of 10,000 or more is preferable.

When the dispersant (including a water-soluble polymer having a dispersing action) is used, a blending proportion thereof is preferably from 0.1 to 2.0 % by mass, and more preferably from 0.3 to 1.5 % by mass with respect to the mass of the cerium oxide particle. When the blending proportion of the dispersant is lower than this range, the dispersibility of the cerium oxide particle that is an abrasive grain is easy to become insufficient. Also, when the blending proportion of the dispersant is higher than this range, there is a tendency that the planarity and polishing rate at the time of polishing are influenced. A blending proportion of the polysilicon film protective agent other than the dispersant is preferably from 0.01 to 10 % by mass, and more preferably from 0.02 to 1.0 % by mass with respect to the total amount of the abrasives. When the blending proportion of the polysilicon film protective agent is lower than this range, etching proceeds so that dishing cannot be suppressed. Also, when the blending proportion of the polysilicon film protective agent is higher than this range, the polishing rate is lowered, and furthermore, the dispersibility is deteriorated.

Each of the first abrasive and the second abrasive is not necessarily supplied into the polishing step as a material in which all of the foregoing constituent components are previously mixed. All of the constituent components may be mixed to formulate the composition of the abrasive first when they are supplied into the polishing step. For example, in the second polishing step, a liquid containing a cerium oxide particle, water and an acid and optionally, a dispersant (for example, ammonium polyacrylate) and a liquid containing a water-soluble amine are separated, followed by properly adjusting a mixing ratio thereof at the time of polishing and using the mixture. Also, the two liquids separated by other separating method may be mixed while properly adjusting a ratio thereof and then used. For example, the second abrasive may be prepared by adding an acid for pH adjustment or the like to a liquid obtained by mixing a cerium oxide particle, a water-soluble polyamine and water and optionally, a dispersant.

In an embodiment of the invention, in the first polishing step, the to-be-polished surface including a polysilicon film is first chemically mechanically polished with the first abrasive containing a cerium oxide particle, water and an acid, thereby planarizing the polysilicon film. Subsequently, in the second polishing step, the polysilicon film planarized in the first polishing step is polished with the second abrasive containing a cerium oxide particle, water and a water-soluble polyamine, and polishing is stopped at a point of time when the silicon dioxide film directly under the polysilicon film is exposed. It is preferable that the second abrasive is prepared by adding water and the water-soluble polyamine to the first abrasive.

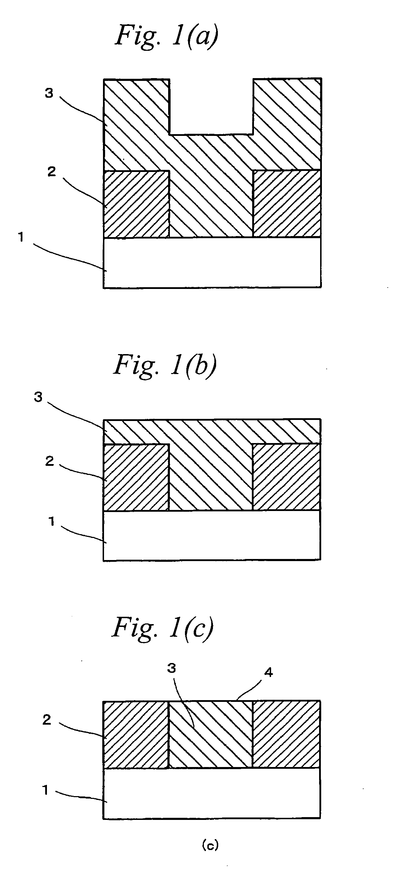

A state in each of the first polishing step and the second polishing step is shown in Figs. 1. Fig. 1(a) is a view schematically showing a section of a semiconductor device before polishing. This semiconductor device has a structure in which a silicon dioxide film 2 as a stopper layer is formed in a pattern shape on a silicon substrate 1, and a polysilicon film 3 is laminated and formed thereon.

In the first polishing step, as shown in Fig. 1(b), the polysilicon film 3 is chemically mechanically polished with the first abrasive containing a cerium oxide particle, water and an acid, whereby the irregularity (difference in level) of the surface (to-be-polished surface) is planarized.

It is preferable that the first polishing step is carried out to an extent that a difference in level between a projection and a recess of the polysilicon film 3 is reduced and becomes substantially planar. When this difference in level becomes small and planar, polishing in the second polishing step as described later becomes easy. However, since there is involved such a problem that the time required for the first polishing step becomes too long, the planarization may be achieved within a practically useful range. For example, the difference in level of a recess and a projection of the polysilicon film 3 is preferably not more than 100 nm, and more preferably not more than 50 nm. The difference in level of the polysilicon film 3 can be measured by a surface level difference meter. Also, the difference in level of the polysilicon film 3 can be calculated from a difference in film thickness between a recess and a projection of the polysilicon film 3. Furthermore, dissolution (planarization) of the difference in level can be detected by knowing a variation in contact resistance between a to-be-polished surface and a polishing pad at the time of polishing from a change in drive current of a polishing table in an automatic polishing machine.
In general, when the projection is reduced by polishing, and the contact area between the to-be-polished surface and the polishing pad increases, the polishing resistance increases. By detecting a point of inflection of the drive current, the difference in level disappears, whereby the planarization can be detected.

Subsequently, in the second polishing step, as shown in Fig. 1(c), the polysilicon film 3 planarized in the first polishing step is polished with the second abrasive containing a cerium oxide particle, water and a water-soluble polyamine. At that time, by setting up a ratio (Vps/Vso) of a polishing rate (Vps) of the polysilicon film 3 and a polishing rate (Vso) of the silicon dioxide film 2 by the second abrasive preferably to 10 or more, and more preferably to 20 or more, the recess and projection of the to-be-polished surface 4 can be highly planarized at a point of time which the silicon dioxide film 2 is exposed.

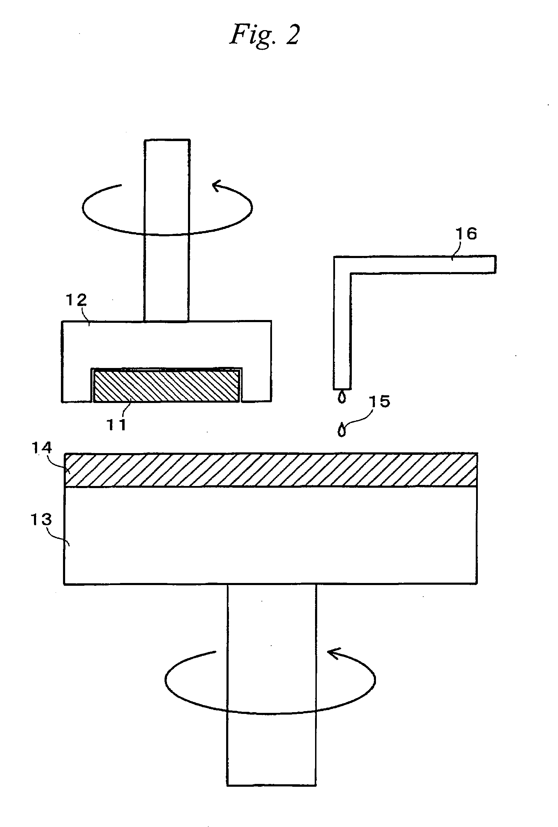

In each of the first polishing step and the second polishing step, a known polishing machine can be used as a polishing machine. Fig. 2 is a view showing an example of a polishing machine which is used for the first embodiment of the invention. This polishing machine is provided with a polishing head 12 for holding a semiconductor device 11 having a to-be-polished surface including a polysilicon film; a polishing table 13; a polishing pad 14 stuck onto the surface of the polishing table 13; and an abrasive supply pipe 16 for supplying an abrasive 15 into the polishing pad 14. Then, the polishing machine is constituted in such a manner that the semiconductor device 11 held by the polishing head 12 is brought into contact with the polishing pad 14 and that the polishing head 12 and the polishing table 13 are rotated for relative movement, thereby polishing. Incidentally, it should not be construed that the polishing machine which is used in the embodiment of the invention is limited to such a structure.

The polishing head 12 may be performed by not only rotation movement but linear movement. Also, the polishing table 13 and the polishing pad 14 may be of the same size as or smaller than the semiconductor substrate 11. In that case, it is preferable to relatively move the polishing head 12 and the polishing table 13, thereby enabling the entire surface of the semiconductor device 11 to be polished. Furthermore, the polishing table 13 and the polishing pad 14 may not be of a rotation movement type, but may be, for example, of a movement type in one direction by a belt system.

Though a polishing condition of such a polishing machine is not particularly limited, by applying a load to the polishing head 12 to press it against the polishing pad 14, it is possible to more raise a polishing pressure and to enhance the polishing rate. The polishing pressure is preferably from about 0.5 to 50 kPa, and from the viewpoints of uniformity of the polishing rate within the semiconductor device 11, planarity and prevention of polishing defects such as a scratch and the like, the polishing pressure is more preferably from about 3 to 40 kPa. A rotation rate of each of the polishing table 13 and the polishing head 12 is preferably from about 50 to 500 rpm. However, the rotation rate is not limited thereto.

As the polishing pad 14, one made of a usual nonwoven fabric, a foamed polyurethane, a porous resin, a non-porous resin or the like can be used. Also, for the purpose of accelerating the supply of the abrasive 15 into the polishing pad 14, or allowing a certain amount of the abrasive 15 to stay in the polishing pad 14, processing with grooves in a lattice, concentric or helical shape or the like may be applied onto the surface of the polishing pad 14.

According to the thus constituted polishing method of the invention, in the manufacture of a semiconductor device, the to-be-polished surface including a polysilicon film can be chemically mechanically polished without generating dishing and highly planarized. Also, in the first polishing step and the second polishing step, since polishing is carried out using the abrasive containing an abrasive grain (cerium oxide particle) of the same kind, the supply mechanism of the abrasive can be simplified, and increases of costs or installation space of equipment can be suppressed. Also, since it is free from aggregation due to mixing of abrasive grains of a different kind, the generation of polishing flaws or deterioration of the planarity is hardly caused.

Also, by polishing the to-be-polished surface of a polysilicon film which is used as a capacitor or a gate electrode by adopting the polishing method of the invention, a highly integrated/highly functionalized semiconductor device can be manufactured.

The manufacture of a semiconductor device can be, for example, carried out according to the following procedures. That is, after a silicon dioxide film is formed on a silicon substrate by a method such as a plasma-CVD method, a low pressure-CVD method, a sputtering method, a spin coating method and the like, a prescribed region of the silicon dioxide film is removed by etching to form an opening; subsequently, the polysilicon film is accumulated on the entire surface of this silicon dioxide film to form a laminated structure shown in Fig. 1(a); thereafter, the first polishing step and the second polishing step are successively carried out to polish the polysilicon film; and polishing is stopped at a point of time when the silicon dioxide film is exposed. In this way, the polysilicon film on the silicon dioxide film is completely removed and planarized while retaining only the polysilicon film within the opening, thereby forming a polysilicon gate or plug.

### EXAMPLES

Examples of the invention are hereunder described. In the Examples, "%" means % by mass unless otherwise indicated. Also, characteristic values were measured and evaluated in the following methods.

### [pH]

The pH was measured at 25°C using pH 81-11, manufactured by Yokogawa Electric Corporation.

### [Average particle size of abrasive grain]

The average particle size of an abrasive grain was determined using a laser scattering/diffraction apparatus (a trade name: LA-920, manufactured by Horiba, Ltd.).

### [Polishing characteristics]

### (1) Polishing condition:

Polishing was carried out using a full automatic CMP polishing machine (a trade name: Mirra, manufactured by Applied Materials). At that time, as a polishing pad, K-groove of a double-layered pad IC-1400, or K-groove of a single-layered pad IC-1000, each of which is manufactured by Rodel, was used, and for conditioning of the polishing pad, MEC100-PH3.5L, manufactured by Mitsubishi Materials Corporation was used. A supply rate of the abrasive was set to 200 mL/min, and rotation rates of the polishing table and the polishing head were set to 127 rpm and 123 rpm, respectively.

### (2) To-be-polished material:

For the measurement of the polishing characteristics of the second abrasive obtained in each of Examples 1 to 16 and Comparative Example 1, an 8-inch silicon wafer substrate prepared by film formation of a polysilicon film by the CVD method, and an 8-inch silicon wafer prepared by film formation of a silicon dioxide film by the thermal oxidation method were used, respectively. Also, for the measurement of the polishing characteristics in each of Examples 17 to 19 and Comparative Examples 2 and 3, an 864-pattem 8-inch silicon wafer prescribed by Semtech, which was obtained by film-forming a silicon dioxide film by the thermal oxidation method, forming an opening by means of lithography and then accumulating a polysilicon film thereon by the CVD method, was used.

### (3) Measurement and evaluation methods of polishing characteristics:

For the measurement of a polishing rate, a film thickness meter UV-1280SE, manufactured by KLA-Tencor was used. For the measurement of a dishing amount, in a pattern structure of an 864-pattern wafer, a structure in which a silicon dioxide film was subjected to linear lithography at intervals of 50 µm, and a polysilicon film was accumulated thereon (usually referred to as a line-and-space with a width of 50 µm) was measured using a profiler P-16, manufactured by KLA-Tencor.

First of all, first abrasives A and B to be used in the first polishing step were prepared.

### [Preparation of first abrasives A and B]

A cerium oxide particle, ammonium polyacrylate having a weight average molecular weight (Mw) of 5,000 and nitric acid were mixed in deionized water with stirring, thereby preparing an abrasive A having a concentration of the cerium oxide particle of 1.0 %, a concentration of ammonium polyacrylate of 850 ppm and a concentration of nitric acid of 420 ppm with respect to the total mass of the liquid. A pH of this abrasive A was 5.0, and an average particle size of the abrasive grain (cerium oxide particle) was 0.17 µm.

Also, a cerium oxide particle, ammonium polyacrylate having a weight average molecular weight (Mw) of 5,000 and oxalic acid were mixed in deionized water with stirring, thereby preparing an abrasive B having a concentration of the cerium oxide particle of 1.0 %, a concentration of ammonium polyacrylate of 850 ppm and a concentration of oxalic acid of 3,040 ppm with respect to the total mass of the liquid. A pH of this abrasive B was 5.0, and an average particle size of the abrasive grain (cerium oxide particle) was 0.17 µm.

Subsequently, the polishing characteristics (the polishing rate of the silicon dioxide film and the polishing rate of the polysilicon film) of the thus obtained first abrasives A and B were measured at a polishing pressure of 13.8 kPa, respectively. The measurement results are shown in Table 1 together with the composition and pH of each of the first abrasives A and B.

**Table 1**

| First abrasive | Concentration of CeO₂ particle (%) | Kind of acid | Concentration of acid (ppm) | Concentration of ammonium polyacrylate (%) | pH | Polishing rate of silicon oxide film (nm/min) | Polishing rate of polysilicon film (nm/min) |
|---|---|---|---|---|---|---|---|
| A | 1.0 | Nitric acid | 420 | 850 | 5.0 | 196 | 3 |
| B | 1.0 | Oxalic acid | 3040 | 850 | 5.0 | 10 | 19 |

### (Examples 1 to 7)

The first abrasive A and deionized water were mixed in a mass ratio of 1/3 (namely, diluted 4 times with deionized water), to which was then added pentaethylenehexamine (PEHA) that is a water-soluble polyamine in an amount of each proportion with respect to the total mass of the liquid as shown in Table 2. There was thus prepared each of abrasives (second abrasives) A1 to A7 having a pH value shown in Table 2.

Subsequently, each of the foregoing to-be-polished materials (the silicon wafer substrate on which a silicon dioxide film had been formed and the silicon wafer substrate on which a polysilicon film had been formed) was polished with each of the thus obtained second abrasives A1 to A7 at a polishing pressure shown in Table 3 for 60 seconds, thereby measuring the polishing characteristics (a polishing rate Vso of the silicon dioxide film and a polishing rate Vps of the polysilicon film), respectively. Then, each of polishing rate ratios (Vps/Vso) of the polysilicon film and the silicon dioxide film was calculated from these measured values. These results are shown in Table 3.

### (Examples 8 and 9)

The first abrasive A and deionized water were mixed in a mass ratio of 1/9 in Example 8 and in a mass ratio of 1/99 in Example 9, respectively, to which was then added PEHA in an amount of 0.1 % with respect to the total mass of the liquid. There was thus prepared each of abrasives (second abrasives) A8 and A9 having a pH value shown in Table 2.

Subsequently, each of the foregoing to-be-polished materials (the silicon wafer substrate on which a silicon dioxide film had been formed and the silicon wafer substrate on which a polysilicon film had been formed) was polished with each of the thus obtained second abrasives A8 and A9 at a polishing pressure shown in Table 3 for 60 seconds, thereby measuring a polishing rate Vso of the silicon dioxide film and a polishing rate Vps of the polysilicon film, respectively. Then, each of polishing rate ratios (Vps/Vso) of the polysilicon film and the silicon dioxide film was calculated from these measured values. These results are shown in Table 3.

### (Examples 10 to 13)

The first abrasive A and deionized water were mixed in a mass ratio of 1/3, to which was then added polyoxypropylene diamine (POPD) (a trade name: Polyether Amine, manufactured by BASF AG) having a weight average molecular weight (Mw) that is a water-soluble polyamine in an amount of each proportion with respect to the total mass of the liquid as shown in Table 2. There was thus prepared each of abrasives (second abrasives) A 10 to A 13 having a pH value shown in Table 2.

Subsequently, each of the foregoing to-be-polished materials (the silicon wafer substrate on which a silicon dioxide film had been formed and the silicon wafer substrate on which a polysilicon film had been formed) was polished with each of the thus obtained second abrasives A10 to A13 at a polishing pressure shown in Table 3 for 60 seconds, thereby measuring a polishing rate Vso of the silicon dioxide film and a polishing rate Vps of the polysilicon film, respectively. Then, each of polishing rate ratios (Vps/Vso) of the polysilicon film and the silicon dioxide film was calculated from these measured values. These results are shown in Table 3.

### (Examples 14 and 15)

The first abrasive A and deionized water were mixed in a mass ratio of 1/9, to which was then added POPD in an amount of each proportion with respect to the total mass of the liquid as shown in Table 2. There was thus prepared each of abrasives (second abrasives) A14 and A15 having a pH value shown in Table 2.

Subsequently, each of the foregoing to-be-polished materials (the silicon wafer substrate on which a silicon dioxide film had been formed and the silicon wafer substrate on which a polysilicon film had been formed) was polished with each of the thus obtained second abrasives A14 and A15 at a polishing pressure shown in Table 3 for 60 seconds, thereby measuring a polishing rate Vso of the silicon dioxide film and a polishing rate Vps of the polysilicon film, respectively. Then, each of polishing rate ratios (Vps/Vso) of the polysilicon film and the silicon dioxide film was calculated from these measured values. These results are shown in Table 3.

### (Example 16)

The first abrasive B and deionized water were mixed in a mass ratio of 1/3, to which was then added POPD in an amount of 0.5 % with respect to the total mass of the liquid. There was thus prepared an abrasive (second abrasive) B1 having a pH value shown in Table 2.

Subsequently, each of the foregoing to-be-polished materials (the silicon wafer substrate on which a silicon dioxide film had been formed and the silicon wafer substrate on which a polysilicon film had been formed) was polished with the thus obtained second abrasive B1 at a polishing pressure of 20.7 kPa for 60 seconds, thereby measuring a polishing rate Vso of the silicon dioxide film and a polishing rate Vps of the polysilicon film, respectively. Then, each of polishing rate ratios (Vps/Vso) of the polysilicon film and the silicon dioxide film was calculated from these measured values. These results are shown in Table 3.

### (Comparative Example 1)

The first abrasive A and deionized water were mixed in a mass ratio of 1/3 to prepare an abrasive A0 having a pH value shown in Table 2. Subsequently, each of the foregoing to-be-polished materials (the silicon wafer substrate on which a silicon dioxide film had been formed and the silicon wafer substrate on which a polysilicon film had been formed) was polished with this abrasive A0 at a polishing pressure of 20.7 kPa for 60 seconds, thereby measuring a polishing rate Vso of the silicon dioxide film and a polishing rate Vps of the polysilicon film, respectively. Then, a polishing rate ratio (Vps/Vso) of the polysilicon film and the silicon dioxide film was calculated from these measured values. These results are shown in Table 3.

**Table 2**

| | Second abrasive | First abrasive | Dilution degree of first abrasive in manufacture of second abrasive | Water-soluble polyamine | Addition proportion of water-soluble polyamine (%) | pH |
|---|---|---|---|---|---|---|
| Example 1 | A1 | A | 4 | PEHA | 0.01 | 7.2 |
| Example 2 | A2 | A | 4 | PEHA | 0.05 | 9.5 |
| Example 3 | A3 | A | 4 | PEHA | 0.1 | 9.9 |
| Example 4 | A4 | A | 4 | PEHA | 0.3 | 10.5 |
| Example 5 | A5 | A | 4 | PEHA | 0.5 | 10.7 |
| Example 6 | A6 | A | 4 | PEHA | 1.0 | 11.0 |
| Example 7 | A7 | A | 4 | PEHA | 2.0 | 11.2 |
| Example 8 | A8 | A | 10 | PEHA | 0.1 | 10.5 |
| Example 9 | A9 | A | 100 | PEHA | 0.1 | 10.7 |
| Example 10 | A10 | A | 4 | POPD | 0.5 | 10.5 |
| Example 11 | A11 | A | 4 | POPD | 0.5 | 10.5 |
| Example 12 | A12 | A | 4 | POPD | 1.0 | 10.8 |
| Example 13 | A 13 | A | 4 | POPD | 2.0 | 11.0 |
| Example 14 | A14 | A | 10 | POPD | 0.3 | 10.6 |
| Example 15 | A15 | A | 10 | POPD | 0.5 | 10.8 |
| Example 16 | B1 | B | 4 | POPD | 0.5 | 10.4 |
| Comparative Example 1 | A0 | A | 4 | None | 0 | 5.4 |

**Table 3**

| | Second abrasive | Polishing pressure (kPa) | Polishing rate of silicon oxide film (nm/min) | Polishing rate of polysilicon film (nm/min) | Polishing rate ratio Vps/Vso |
|---|---|---|---|---|---|
| Example 1 | A1 | 20.7 | 5 | 366 | 69.2 |
| Example 2 | A2 | 20.7 | 5 | 445 | 87.9 |
| Example 3 | A3 | 20.7 | 4 | 466 | 105.9 |
| Example 4 | A4 | 20.7 | 4 | 387 | 104.0 |
| Example 5 | A5 | 20.7 | 4 | 299 | 82.8 |
| Example 6 | A6 | 20.7 | 3 | 104 | 32.1 |
| Example 7 | A7 | 20.7 | 3 | 88 | 27.4 |
| Example 8 | A8 | 20.7 | 3 | 391 | 135.9 |
| Example 9 | A9 | 20.7 | 1 | 52 | 42.6 |
| Example 10 | A10 | 20.7 | 7 | 137 | 18.6 |
| Example 11 | A11 | 27.6 | 10 | 203 | 20.9 |
| Example 12 | A12 | 27.6 | 7 | 170 | 24.3 |
| Example 13 | A13 | 27.6 | 5 | 139 | 25.8 |
| Example 14 | A14 | 20.7 | 8 | 166 | 20.2 |
| Example 15 | A15 | 20.7 | 5 | 86 | 16.6 |
| Example 16 | B1 | 20.7 | 7 | 120 | 16.3 |
| Comparative Example 1 | A0 | 20.7 | 240 | 2 | 0.007 |

From the measurement results of Table 3, it is noted that in the second abrasives of Examples 1 to 16 obtained by adding water and the water-soluble polyamine to the first abrasive containing the cerium oxide particle, the dispersant, the acid and water, the polishing rate ratio (Vps/Vso) of the polysilicon film and the silicon dioxide film is extremely large as 15 or more. Accordingly, it is noted that in polishing the to-be-polished surface including a polysilicon film, each of the abrasives of Examples 1 to 16 is able to efficiently achieve high planarization using the silicon dioxide film as a stopper film. On the other hand, in the abrasive A0 of Comparative Example 1, since the first abrasive A is merely diluted with water, but the water-soluble polyamine is not added, the polishing rate ratio (Vps/Vso) is extremely small. Accordingly, it is noted that the resulting abrasive cannot be used for polishing using the silicon dioxide film as a stopper film.

### (Example 17)

In the first polishing step, the foregoing to-be-polished material (864-pattern 8-inch silicon wafer) was polished with the abrasive A at a polishing pressure of 13.8 kPa for 120 seconds. After the first polishing step, a difference in level between a projection (line part) and a recess (space part) of the polysilicon film was measured by a surface level difference meter. As a result, the difference in level was not more than 50 nm, so that the polysilicon film was confirmed to be thoroughly planarized.

Subsequently, in the second polishing step, the to-be-polished material in which the polysilicon film had been thus planarized was polished with the second abrasive A3 obtained in Example 3 at a polishing pressure of 6.9 kPa. Polishing was carried out for 20 seconds until the polysilicon film on the silicon dioxide film disappeared. The matter that the polysilicon film on the silicon dioxide film was completely removed was confirmed by measuring the thickness of the polysilicon film by a film thickness meter. Then, a dishing amount after the second polishing step was measured. The measurement results are shown in Table 4 together with the evaluation results of a degree of simplification of the abrasive supply apparatus and a concern of incorporation of particles of a different kind.

### (Example 18)

The first polishing step was carried out in the same manner as in Example 17, thereby planarizing the polysilicon film. Thereafter, in the second polished step, the planarized polysilicon film was polished with the second abrasive A11 obtained in Example 11 at a polishing pressure of 20.7 kPa. Incidentally, polishing in the second polishing step was carried out until the polysilicon film on the silicon dioxide film disappeared, so that the silicon dioxide film was exposed. A time of the second polishing step was 90 seconds. Then, a dishing amount after the second polishing step was measured. The measurement results are shown in Table 4 together with the evaluation results of a degree of simplification of the abrasive supply apparatus and a concern of the generation of polishing flaws due to incorporation of particles of a different kind.

### (Example 19)

In the first polishing step, polishing with the first abrasive B was carried out at a polishing pressure of 13.8 kPa for 120 seconds, thereby planarizing the polysilicon film. Thereafter, in the second polished step, the planarized polysilicon film was polished with the second abrasive B1 obtained in Example 16 at a polishing pressure of 20.7 kPa. Incidentally, polishing in the second polishing step was carried out until the polysilicon film on the silicon dioxide film disappeared, so that the silicon dioxide film was exposed. A time of the second polishing step was 10 seconds. Then, a dishing amount after the second polishing step was measured. The measurement results are shown in Table 4 together with the evaluation results of a degree of simplification of the abrasive supply apparatus and a concern of the generation of polishing flaws due to incorporation of particles of a different kind.

### (Comparative Example 2)

The first polishing step was carried out in the same manner, thereby planarizing the polysilicon film. Thereafter, in the second polishing step, the planarized polysilicon film was polished at a polishing pressure of 6.9 kPa by using an abrasive C obtained by 20-fold dilution of an abrasive (Planerite 6103, manufactured by Fujimi Incorporated) containing colloidal silica, water and a basic organic compound by the addition of deionized water. Incidentally, polishing in the second polishing step was carried out for 40 seconds until the polysilicon film on the silicon dioxide film disappeared, so that the silicon dioxide film was exposed. Then, a dishing amount after the second polishing step was measured. The measurement results are shown in Table 4 together with the evaluation results of a degree of simplification of the abrasive supply apparatus and a concern of the generation of polishing flaws due to incorporation of particles of a different kind.

### (Comparative Example 3)

The foregoing to-be-polished material (864-pattern 8-inch silicon wafer) was polished with the abrasive C used in Comparative Example 2 in one stage. That is, the polysilicon film on the silicon dioxide film was polished at a polishing pressure of 6.9 kPa until the silicon dioxide film was exposed. A time required for polishing was 75 seconds. Then, a dishing amount after completion of polishing was measured. The measurement results are shown in Table 4 together with the evaluation results of a degree of simplification of the abrasive supply apparatus and a concern of the generation of polishing flaws due to incorporation of particles of a different kind.

**Table 4**

| | First abrasive | Second abrasive | Time of second polishing step (sec) | Polishing pressure of second abrasive step (kPa) | Dishing amount (nm) | Simplification of supply apparatus | Concern of the generation of polishing flaws due to incorporation of particles of a different kind |
|---|---|---|---|---|---|---|---|
| Example 17 | A | A3 | 20 | 6.9 | 24 | Good | Not concerned |
| Example 18 | A | A11 | 90 | 20.7 | 32 | Good | Not concerned |
| Example 19 | B | B1 | 10 | 20.7 | 50 | Good | Not concerned |
| Comparative Example 2 | A | C | 40 | 6.9 | 36 | Bad | Concerned |
| Comparative Example 3 | C | None | None | - | 101 | - | - |

From the measurement results of Table 4, the following were noted. That is, it was noted that according to Examples 17 to 19, the dishing amount became a half or less as compared with that in Comparative Example 3 in which polishing was carried out in one stage by using the conventional abrasive C (containing colloidal silica, water and the basic organic compound); and that by carrying out polishing in two stages, the to-be-polished surface with very high planarity was obtained. Also, in Examples 17 to 19, since in all of the first polishing step and the second polishing step, polishing is carried out using the abrasive containing a cerium oxide particle, it was noted that not only the supply mechanism of the abrasive can be simplified as compared with Comparative Example 2 in which the kind of the abrasive grain is different between the first polishing step and the second polishing step, but also there is no concern of mixing of abrasive grains of a different kind and the generation of polishing flaws due to mixing.

While the invention has been described in detail and with reference to specific embodiments thereof, it will be apparent to one skilled in the art that various changes and modifications can be made therein without departing from the spirit and scope thereof.
This application is based on Japanese Patent Application No. 2008-286366 filed on November 7, 2008, the contents of which are incorporated herein by way of reference.

### INDUSTRIAL APPLICABILITY

According to the abrasive and the polishing method of the invention, in manufacturing a semiconductor integrated circuit device, in the case of polishing a to-be-polished surface including a polysilicon film having a silicon dioxide film directly thereunder, the to-be-polished surface which is small in dishing and which is highly planarized can be efficiently obtained. Accordingly, a yield of the semiconductor integrated circuit device can be enhanced. Also, since a polishing time of a pattern wafer can be shortened, a throughput can also be enhanced.

### DESCRIPTION OF REFERENCE NUMERALS AND SIGNS

1: Silicon substrate
2: Silicon dioxide film
3: Polysilicon film
4: To-be-polished surface after polishing
11: Semiconductor device
12: Polishing head
13: Polishing table
14: Polishing pad
15: Abrasive
16: Abrasive supply pipe

## Claims

1. A polishing method for polishing a to-be-polished surface including a polysilicon film having a silicon dioxide film directly thereunder, in manufacturing a semiconductor integrated circuit device, the method comprising:
a first polishing step of polishing and planarizing the polysilicon film with a first abrasive containing a cerium oxide particle, water and an acid; and
a second polishing step of polishing the polysilicon film planarized in the first polishing step with a second abrasive containing at least a cerium oxide particle, water, an acid and a water-soluble polyamine or a salt thereof and stopping polishing by exposure of the silicon dioxide film.

2. The polishing method according to claim 1, wherein the second abrasive is an abrasive prepared by adding a water-soluble polyamine and water to the first abrasive.

3. The polishing method according to claim 1 or 2, wherein the water-soluble polyamine is at least one compound selected from the group consisting of a water-soluble polyether polyamine and a water-soluble polyalkylene polyamine.

4. The polishing method according to any one of claims 1 to 3, wherein the water-soluble polyamine has a weight average molecular weight of from 100 to 100,000.

5. The polishing method according to claim 3, wherein the water-soluble polyamine is at least one selected from pentaethylenehexamine and polyoxypropylene diamine.

6. The polishing method according to any one of claims 1 to 5, wherein the water-soluble polyamine or the salt thereof is contained in an amount of from 0.01 to 20 % by mass with respect to the total mass of the abrasive.

7. The polishing method according to claim 1 or 2, wherein each of the first abrasive and the second abrasive contains a water-soluble polymer having a carboxylic acid group or a carboxylate, a valence of which acid is 20 or more.

8. The polishing method according to claim 7, wherein the water-soluble polymer is polyacrylic acid or ammonium polyacrylate.

9. The polishing method according to any one of claims 1 to 8, wherein at least one of the first polishing step and the second polishing step includes a step of supplying the first abrasive or the second abrasive to a polishing pad, bringing the polishing pad into contact with the to-be-polished surface and polishing by relative movement therebetween.

10. An abrasive for polishing a to-be-polished surface including a polysilicon film having a silicon dioxide film directly thereunder, in manufacturing a semiconductor integrated circuit device, the abrasive containing a cerium oxide particle, water, an acid and a water-soluble polyamine or a salt thereof; and having a pH of from 7 to 13.

11. The abrasive according to claim 10, wherein the water-soluble polyamine is at least one compound selected from the group consisting of a water-soluble polyether polyamine and a water-soluble polyalkylene polyamine.

12. The abrasive according to claim 10 or 11, wherein the water-soluble polyamine has a weight average molecular weight of from 100 to 100,000.

13. The abrasive according to claim 11, wherein the water-soluble polyamine is at least one selected from pentaethylenehexamine and polyoxypropylene diamine.

14. The abrasive according to any one of claims 10 to 13, wherein the water-soluble polyamine or the salt thereof is contained in an amount of from 0.01 to 20 % by mass with respect to the total mass of the abrasive.

15. The abrasive according to any one of claims 10 to 14, wherein the abrasive contains a water-soluble polymer having a carboxylic acid group or a carboxylate, a valence of which acid is 20 or more.

16. The abrasive according to claim 15, wherein the water-soluble polymer is polyacrylic acid or ammonium polyacrylate.

17. A method for manufacturing a semiconductor integrated circuit device, the method including a step of polishing a to-be-polished surface by the polishing method according to any one of claims 1 to 9.
